(19) Europäisches Patentamt
European Patent Office
Office européen des brevets

(11) **EP 2 425 434 B1**

(12) **FASCICULE DE BREVET EUROPEEN**

(45) Date de publication et mention de la délivrance du brevet:
**27.01.2016 Bulletin 2016/04**

(21) Numéro de dépôt: **10715869.3**

(22) Date de dépôt: **30.04.2010**

(51) Int Cl.:
*G11C 11/14* (2006.01)    *G11C 11/54* (2006.01)
*G11C 11/16* (2006.01)

(86) Numéro de dépôt international:
**PCT/EP2010/055902**

(87) Numéro de publication internationale:
**WO 2010/125181 (04.11.2010 Gazette 2010/44)**

(54) **DISPOSITIF MEMRISTOR À RÉSISTANCE AJUSTABLE GRÂCE AU DÉPLACEMENT D'UNE PAROI MAGNÉTIQUE PAR TRANSFERT DE SPIN ET UTILISATION DUDIT MEMRISTOR DANS UN RÉSEAU DE NEURONES.**

MEMRISTOR-BAUELEMENT MIT EINEM WIDERSTAND, DER DURCH BEWEGEN EINER MAGNETISCHEN WAND DURCH SPINTRANSFER EINSTELLBAR IST, UND VERWENDUNG DES MEMRISTORS IN EINEM NEURONALEN NETZWERK

MEMRISTOR DEVICE WITH RESISTANCE ADJUSTABLE BY MOVING A MAGNETIC WALL BY SPIN TRANSFER AND USE OF SAID MEMRISTOR IN A NEURAL NETWORK.

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **30.04.2009 FR 0902122**

(43) Date de publication de la demande:
**07.03.2012 Bulletin 2012/10**

(73) Titulaires:
• **THALES**
**92200 Neuilly-sur-Seine (FR)**
• **Centre National de la Recherche Scientifique**
**75016 Paris (FR)**

(72) Inventeurs:
• **GROLLIER, Julie**
**F-75013 Paris (FR)**
• **CROS, Vincent**
**F-75011 Paris (FR)**
• **NGUYEN VAN DAU, Frédéric**
**F-91120 Palaiseau (FR)**

(74) Mandataire: **Lucas, Laurent Jacques et al**
**Marks & Clerk France**
**Conseils en Propriété Industrielle**
**Immeuble Visium**
**22, Avenue Aristide Briand**
**94117 Arcueil Cedex (FR)**

(56) Documents cités:
**WO-A1-2006/064022       US-A1- 2006 237 808**
**US-A1- 2007 242 505**

• **R. STANLEY WILLIAMS: "How We Found The Missing Memristor" SPECTRUM, IEEE vol. 42, no. 12, 1 décembre 2008 (2008-12-01), pages 29-35, XP002569124 ISSN: 0018-9235 Extrait de l'Internet: URL:http://ieeexplore.ieee.org/stamp/stamp .jsp?tp=&arnumber=4687366 [extrait le 2010-02-17]**
• **XIAOBIN WANG ET AL: "Spintronic Memristor Through Spin-Torque-Induced Magnetization Motion" IEEE ELECTRON DEVICE LETTERS, IEEE SERVICE CENTER, NEW YORK, NY, US, vol. 30, no. 3, 1 mars 2009 (2009-03-01), pages 294-297, XP011251008 ISSN: 0741-3106**
• **SAFFARZADEH A ET AL: "Quantum theory of tunneling magnetoresistance in GaMnAs/GaAs/ GaMnAs heterostructures" JOURNAL OF MAGNETISM AND MAGNETIC MATERIALS, ELSEVIER SCIENCE PUBLISHERS, AMSTERDAM, NL, vol. 305, no. 1, 1 octobre 2006 (2006-10-01), pages 141-146, XP024984924 ISSN: 0304-8853 [extrait le 2006-10-01]**

**Description**

La présente invention concerne un dispositif à résistance ajustable, couramment appelé memristor, fonctionnant grâce au déplacement d'une paroi magnétique par transfert de spin. Elle s'applique par exemple dans le domaine des circuits neuromimétiques du type réseaux neuronaux sur puce et plus généralement aux architectures de calculateurs bio-inspirés.

Ces 50 dernières années, l'informatique purement numérique de type Von Neumann a fait des progrès considérables. Cependant, même les ordinateurs les plus puissants dotés des algorithmes les plus évolués ne parviennent pas à réaliser rapidement des traitements en apparence simples, tels que l'interprétation d'images, pourtant réalisés en une fraction de seconde par le cerveau humain. Ce dernier en effet fonctionne de manière massivement parallèle et analogique, contrairement aux ordinateurs actuels. Les circuits neuromimétiques analogiques réalisés sur puce, qui tentent de reproduire le fonctionnement du cerveau humain, peuvent permettre d'aller au-delà des architectures conventionnelles. Les architectures à réseaux de neurones fonctionnent à partir de méthodes d'apprentissage : un circuit est entraîné à réagir de la façon désirée à une entrée donnée. Ceci est obtenu en ajustant les valeurs des composants du circuit de manière à converger vers la sortie souhaitée pour une entrée donnée. Une implémentation sur puce requiert donc l'utilisation de composants nanométriques, analogiques, reconfigurables et rapides.

Jusqu'en 2008, les circuits neuromimétiques sur puces étaient entièrement réalisés avec des transistors. Notamment, plusieurs transistors étaient utilisés pour reproduire la plasticité d'une seule synapse connectant deux neurones.

Mais en 2008, l'équipe de Hewlett-Packard dirigée par Stanley Williams a publié plusieurs brevets et articles où il est proposé de réaliser des circuits neuronaux en utilisant un transistor par neurone et un « memristor » par synapse connectant deux neurones (D. B. Strukov et al., Nature 453, 80 (2008) et J.J. Yang et al., Nature Nano. 3, 429 (2008)). Un memristor est une résistance nanométrique de valeur configurable dans une plage continue par la charge électrique qui l'a précédemment traversée. Dans le cas présent des circuits neuronaux, son application principale est de simuler sur puce la plasticité des synapses. Un memristor de Hewlett-Packard forme une structure comportant une couche isolante inséré entre des couches métalliques ordinaires. En appliquant un courant à la structure, des lacunes d'oxygène se créent, qui vont migrer sous l'effet de la tension et induire un changement de résistance. Le fonctionnement de ces memristors repose donc sur l'effet d'électromigration des ions. Malheureusement, cet effet d'électromigration des ions implique des températures de fonctionnement élevées et donc une fragilité potentielle du dispositif. Mais surtout, cet effet d'électromigration des ions implique une vitesse de fonctionnement faible puisque liée à la mobilité des ions: la résistance des memristors de Hewlett-Packard varie très lentement.

C'est pourquoi la demanderesse s'est orientée vers une technologie radicalement différente de celles utilisées dans les memristors connus, à savoir la magnétorésistance. En effet, la demanderesse a démontré expérimentalement qu'il est possible de déplacer une paroi magnétique dans un élément magnétique par transfert de spin, dans un sens ou dans l'autre suivant le signe du courant appliqué à l'élément magnétique. La demanderesse a notamment mesuré cet effet dans des vannes de spin, qui sont des dispositifs dans lesquels deux couches magnétiques sont séparées par une couche métallique (J. Grollier et al., Appl. Phys. Lett. 83, 509 (2003)). Et il a été récemment suggéré (X. Wang et al., IEEE Electron Device Letters 30, 741 (2009)) que ces vannes de spin pourraient peut-être permettre de réaliser des memristors. Etonnamment, cette dernière publication ne donne aucun détail d'implémentation, alors que la réalisation d'un memristor à partir d'une vanne de spin est difficile à envisager. Ceci est dû au fait que l'effet memristif dans les vannes de spin est négligeable, car la magnétorésistance y est faible, de l'ordre de 10%. Une vanne de spin ne peut donc que fournir une résistance de valeur très faible. C'est pourquoi la réalisation d'un memristor à partir d'une vanne de spin est difficile à envisager.

La demanderesse a déposé en 2005 une demande internationale de brevet No. WO 2006/064022 A1, qui divulgue un dispositif comportant deux éléments magnétiques séparés par un élément isolant. Le dispositif permet de commuter de manière reproductible entre deux états d'aimantation stables et identifiables à des états logiques "0" ou "1 ", permettant ainsi de stocker de l'information. La commutation entre les deux états d'aimantation se fait par déplacement d'une paroi magnétique dans l'un des éléments magnétiques entre deux positions stables. Malheureusement, ce dispositif ne permet pas de faire varier continûment la résistance dans une plage, car la paroi magnétique n'a que deux positions stables vers lesquels elle tend irrémédiablement. Il ne fournit donc que deux valeurs de résistance, correspondant chacune à l'un des deux états d'aimantation. Il ne s'agit donc pas d'un memristor.

L'invention a notamment pour but de fournir un memristor magnétorésistif, c'est-à-dire une résistance dont la valeur peut être ajustée dans une plage large et continue, en exploitant le déplacement d'une paroi magnétique par transfert de spin. On tend à atteindre cet objectif au moyen d'un procédé selon la revendication 1.

Dans un mode de réalisation préférentiel, les moyens pour déplacer la paroi magnétique le long du barreau peuvent inclure au moins deux électrodes disposées sur la première couche magnétique et/ou sur la deuxième couche magnétique, lesdites électrodes permettant d'appliquer au barreau le courant électrique polarisé en spin.

Avantageusement, la paroi magnétique ne peut se déplacer le long du barreau que lorsque le courant polarisé en spin appliqué entre les électrodes a une densité de courant supérieure à un seuil donné. Au-dessus de ce seuil, l'amplitude de déplacement de la paroi magnétique le long du barreau peut varier linéairement avec la durée d'application entre les électrodes du courant polarisé en spin. Le signe du courant polarisé en spin appliqué entre les électrodes peut déterminer le sens de déplacement de la paroi magnétique le long du barreau.

Le dispositif peut comporter un réservoir de nucléation à une extrémité du barreau, de manière à faciliter la création de la paroi magnétique.

Dans un mode de réalisation, la paroi magnétique dans la première couche magnétique peut être située à une extrémité du barreau, la première couche ayant alors une seule direction d'aimantation homogène sensiblement parallèle à l'axe longitudinal du barreau, de telle sorte que la résistance du dispositif est égale à l'une des bornes de la plage continue de valeurs. Le dispositif peut alors être utilisé comme synapse excitatrice entre deux neurones dans un réseau de neurones, le courant appliqué au barreau permettant de diminuer la valeur de la résistance à partir de la borne maximale de la plage continue de valeurs. Le dispositif peut également être utilisé comme synapse inhibitrice entre deux neurones, le courant appliqué au barreau permettant d'augmenter la valeur de la résistance à partir de la borne minimale de la plage continue de valeurs. Le dispositif peut aussi comporter des pièges artificiels pour la paroi, de manière à reproduire des fonctions synaptiques.

Par exemple, la première couche magnétique peut être une couche ferromagnétique, comme un matériau magnétique à anisotropie planaire du type d'un alliage NiFe ou d'un alliage CoFeB, ou encore un matériau magnétique à anisotropie perpendiculaire du type d'un alliage CoPt, ou d'un alliage FePt, ou d'un alliage FePd, ou d'un empilement Co/Ni, ou d'un empilement Co/Al$_2$0$_3$.

Par exemple, les deux couches magnétiques peuvent être séparées par une couche isolante contenant de l'oxyde d'aluminium Al$_2$0$_3$ ou de l'oxyde de magnésium MgO. Elles peuvent également être séparées par une couche semi-conductrice contenant de l'arséniure de gallium GaAs ou un composé à base de GaAs.

Par exemple, la deuxième couche magnétique peut également être une couche ferromagnétique. Elle peut notamment contenir du cobalt, ou un alliage NiFe, ou un alliage CoPt, ou un alliage FePt, ou un alliage FePd, ou un empilement Co/Ni ou un empilement Co/Al$_2$0$_3$. Elle peut également contenir un antiferromagnétique synthétique du type CoFeB/Ru/CoFeB.

L'invention a encore pour principaux avantages que, par exploitation de l'effet de magnétorésistance, elle fournit une résistance dont la valeur peut être ajustée rapidement et jusqu'à des valeurs assez élevées. En effet, il a été récemment démontré qu'une paroi poussée par transfert de spin peut atteindre 175 m/s. Cela signifie que la résistance d'un memristor selon l'invention de taille sub-micrométrique basé sur le transfert de spin peut être ajustée par injection de courant en quelques nanosecondes ou moins. Enfin, l'invention limite les risques de détérioration du composant, car les densités de courant mises en jeu pour mettre en mouvement une paroi magnétique par transfert de spin sont inférieures à $10^8$ A.cm$^{-2}$ (ampère/cm$^2$), c'est-à-dire bien inférieures à celles mises en jeu dans les techniques d'électromigration.

D'autres caractéristiques et avantages de l'invention apparaîtront à l'aide de la description qui suit faite en regard de dessins annexés qui représentent :

- la figure 1, par un schéma, une illustration d'un exemple de memristor magnéto-résistif selon l'invention;
- la figure 2, par deux schémas, une illustration d'un exemple de memristor magnéto-résistif selon l'invention, utilisé comme synapse dans un réseau de neurones;
- la figure 3, par une vue en perspective, une illustration d'un exemple de memristor magnéto-résistif selon l'invention en forme de barreau;
- la figure 4, par des vues de dessus, des illustrations de plusieurs exemples de memristors magnéto-résistifs selon l'invention ayant des formes complexes;
- la figure 5, par une vue latérale et par une vue de dessus, une illustration d'un exemple d'électrodes de commande d'un memristor magnéto-résistif selon l'invention;
- la figure 6, par une vue latérale, une illustration d'un exemple de memristor magnéto-résistif selon l'invention lors de l'écriture de son état initial;
- la figure 7, par une vue latérale, une illustration d'un exemple de memristor magnéto-résistif selon l'invention lors de la lecture de son état de résistance;
- la figure 8, par une vue latérale, une illustration d'un exemple de memristor magnéto-résistif selon l'invention lors de l'écriture d'un état de résistance différent de son état initial.

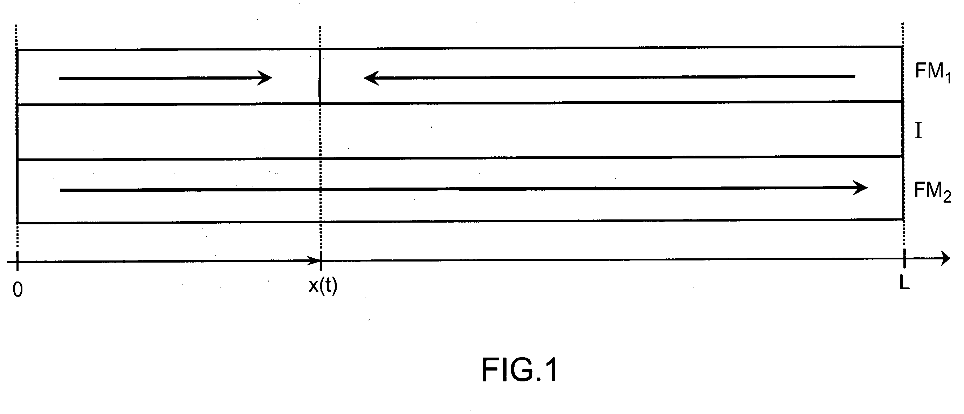

La figure 1 illustre par un schéma un exemple de memristor magnéto-résistif selon l'invention, comportant deux éléments magnétiques FM$_1$ et FM$_2$ formant des couches allongées de longueur L, les éléments FM$_1$ et FM$_2$ étant séparés par un élément non magnétique I formant également une couche allongée de longueur L. La couche I est un isolant ou un semi-conducteur. La direction des aimantations dans les deux couches magnétiques FM$_1$ et FM$_2$ sont schématisées par des flèches. Ainsi, dans le cas de la figure 1, une paroi magnétique est présente dans FM$_1$ à une position x qui peut varier avec le temps t, alors que l'aimantation est homogène dans FM$_2$ qui ne présente pas de paroi magnétique.

La résistance R d'une telle structure magnétorésistive est différente selon la configuration des aimantations dans les deux couches. Si les aimantations sont orientées dans le même sens, la configuration est alors dite "parallèle", c'est-à-dire les deux flèches dans le même sens sur la figure 1, et la résistance est notée R=R$_P$.

Si les aimantations sont orientées dans des directions opposées, la configuration est alors dite "antiparallèle", c'est-à-dire les deux flèches en sens inverses sur la figure 1, et la résistance est notée $R=R_{AP}$. Ainsi, la résistance R de la structure est donnée par l'égalité suivante :

$$R = R_P \frac{x}{L} + R_{AP} \left(1 - \frac{x}{L}\right)$$

Avantageusement, en injectant un courant polarisé en spin à travers la paroi, il est possible de la déplacer dans un sens ou dans l'autre suivant le signe du courant par effet de transfert de spin. Avantageusement, pour des densités de courant supérieures à une valeur critique $J_c$ définie notamment par le piégeage initial de la paroi, la vitesse u de propagation de la paroi par transfert de spin est proportionnelle au courant i injecté selon u= $\gamma$i où $\gamma$ est un coefficient donné. Avantageusement là encore, la paroi ne bouge pas en dessous de $J_c$ (u=0) et le déplacement x à l'instant t est donné par x(t)= $\gamma$it=$\gamma$q, où q est la charge totale injectée. La résistance du dispositif dépend donc bien de la charge et pas seulement du courant: c'est ce qui est à l'origine de l'effet mémoire du memristor. Ainsi, pour un échantillon parfait sans centre de piégeage, la "memristance" M en fonction de la charge q est donnée par l'égalité (1) suivante :

$$M(q) = R_{AP} \left(1 - \frac{R_{AP} - R_P}{R_{AP}} \frac{\gamma}{L} q\right)$$

Par conséquent, puisque la résistance du dispositif est fonction de la charge, il s'agit bien d'un dispositif multi-états de résistance contrôlable par la charge injectée, grâce au déplacement de paroi par transfert de spin. Et en l'absence de courant appliqué, le dispositif conserve sa dernière valeur de résistance.

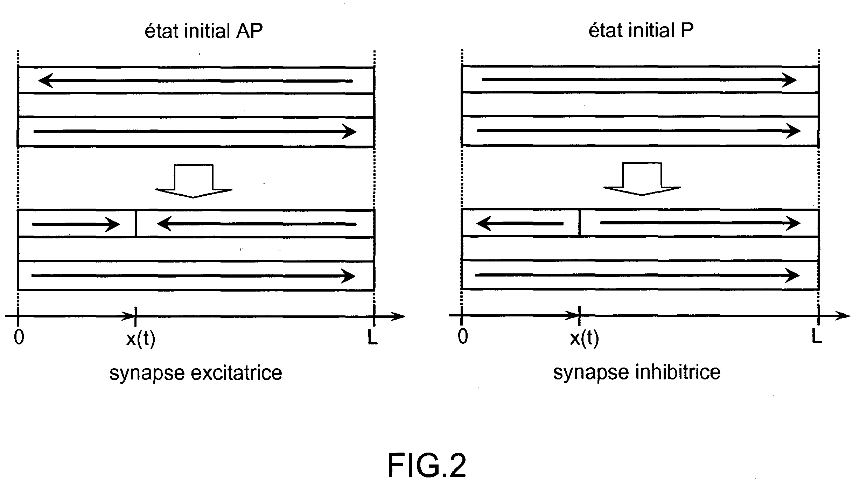

La figure 2 illustre par des schémas comment un memristor magnéto-résistif selon l'invention peut avantageusement être utilisé comme synapse dans un réseau de neurones. En effet, pour une même polarité du courant injecté, c'est-à-dire pour un même sens de propagation de la paroi magnétique, un memristor magnéto-résistif selon l'invention permet d'implémenter soit une synapse excitatrice, soit une synapse inhibitrice. Une synapse excitatrice est d'autant plus conductrice qu'elle est souvent sollicitée, alors qu'une synapse inhibitrice devient plus isolante à chaque fois qu'elle est stimulée. Ainsi, comme illustré sur la figure 2 dans le cas où $R_{AP}>R_P$, en changeant simplement la direction de l'aimantation de la couche FM$_2$, le memristor magnéto-résistif selon l'invention peut être utilisé soit comme synapse artificielle excitatrice, d'état initial antiparallèle AP dont la résistance diminue quand on lui applique un courant, soit comme synapse artificielle inhibitrice, d'état initial parallèle P dont la résistance augmente quand on lui applique un courant. En changeant la polarité du courant injecté, il est également possible de passer d'un comportement de synapse excitatrice à une synapse inhibitrice.

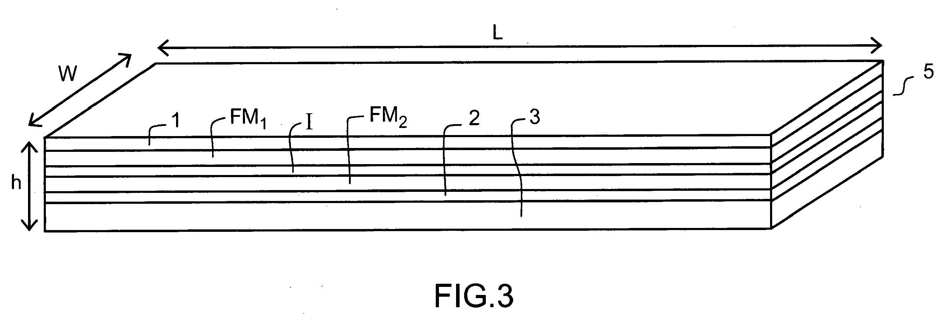

La figure 3 illustre par une vue en perspective un exemple de memristor magnéto-résistif selon l'invention en forme de barreau 5. Le barreau peut être de longueur L pouvant varier de quelques centaines de nanomètres à quelques microns. La largeur w du barreau 5 peut être de l'ordre de la centaine de nanomètres ou moins. L'épaisseur h de l'empilement magnétique formé par le memristor peut être de l'ordre de quelques dizaines de nanomètres. Une couche 1 forme avantageusement une couche de protection de la couche FM$_1$, typiquement Au, Ru, Ta ou un empilement plus complexe de ces matériaux. La couche 1 peut éventuellement être omise si le matériau constituant FM$_1$ le permet. La couche FM$_1$ peut être une couche ferromagnétique où va se propager la paroi magnétique. Il peut s'agir d'un matériau à anisotropie planaire, tel qu'un alliage NiFe, ou CoFeB. Pour réduire la dimension de la paroi à quelques dizaines de nanomètres ou moins et donc réduire L à la centaine de nanomètres, des matériaux à anisotropie perpendiculaire peuvent être utilisés, tels que des alliages CoPt, FePt, FePd, ou encore un empilement de couches de Cobalt et de Nickel (empilement désigné Co/Ni par la suite) ou encore un empilement de couches de Cobalt et d'oxyde d'aluminium (empilement désigné Co/Al$_2$O$_3$ par la suite). La couche I peut être un isolant ou un matériau semi-conducteur. En effet, l'effet magnéto-résistif exploité par l'invention est l'effet de magnétorésistance tunnel, qui peut aller jusqu'à 600%, ceci afin de maximiser l'amplitude de variation de la résistance entre $R_P$ et $R_{AP}$ et ainsi élargir la plage de résistance. Si I est un isolant, il peut s'agir par exemple d'une barrière tunnel telle que Al$_2$O$_3$ ou MgO. Si I est un semi-conducteur, il peut s'agir par exemple de GaAs. La couche FM$_2$ est une couche ferromagnétique dont l'aimantation reste fixe. Il peut s'agir par exemple soit d'un ferromagnétique simple du type Co, NiFe, CoPt, FePt, FePd, CoNi ou CoAl203, soit d'un antiferromagnétique synthétique du type CoFeB/Ru/CoFeB. La couche 2, qui peut éventuellement être omise, forme avantageusement une couche permettant de piéger l'aimantation de FM$_2$, typiquement un matériau antiferromagnétique tel que IrMn, PtMn ou CoO. La couche 3 forme avantageusement une couche tampon qui peut être utile pour une bonne croissance des matériaux, typiquement Ta, Ru ou un empilement plus complexe des deux.

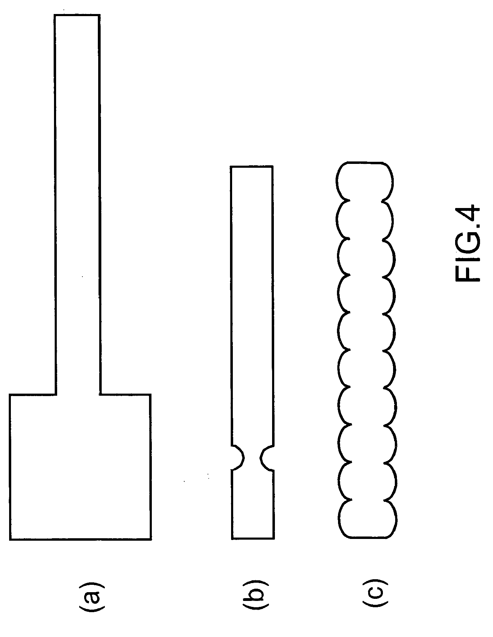

La figure 4 illustre par des vues de dessus des exemples de memristors magnéto-résistifs selon l'invention de formes plus complexes. En effet, un réservoir de nucléation peut être utilisé pour faciliter la création de la paroi, comme schématisé par l'exemple (a) de la figure 4. Pour obtenir des memristances plus complexes que celle de l'équation (1) et ainsi pouvoir reproduire des fonctions synaptiques, des pièges artificiels pour la paroi magnétique peuvent être introduits de manière contrôlée, comme schématisés par les exemples (b) et (c) de la figure 4.

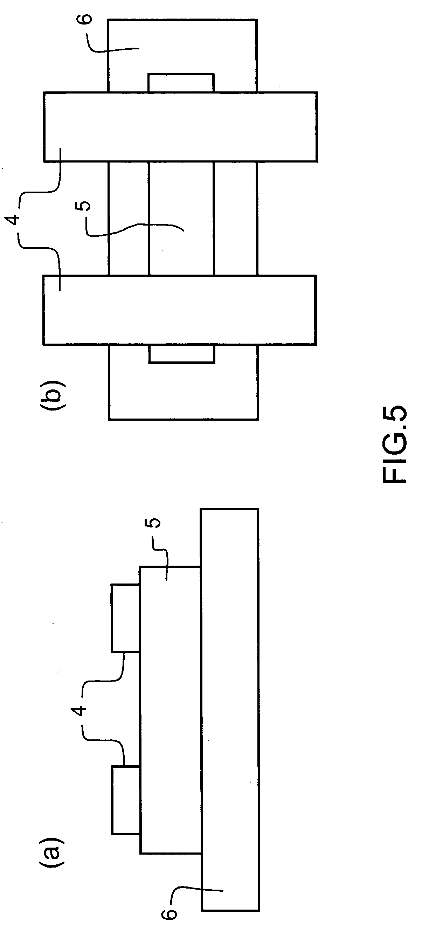

La figure 5 illustre par une vue latérale (a) et par une vue de dessus (b) le même exemple de memristor magnéto-résistif selon l'invention en forme de barreau 5 que celui de la figure 3, mais en faisant apparaître en plus des électrodes de commande pour l'écriture puis la lecture de l'état de résistance. Des électrodes 4 peuvent avantageusement être situées en haut du memristor, qui peut comporter d'autres électrodes comme les électrodes 4. Une électrode 6 peut avantageusement être située en bas du memristor.

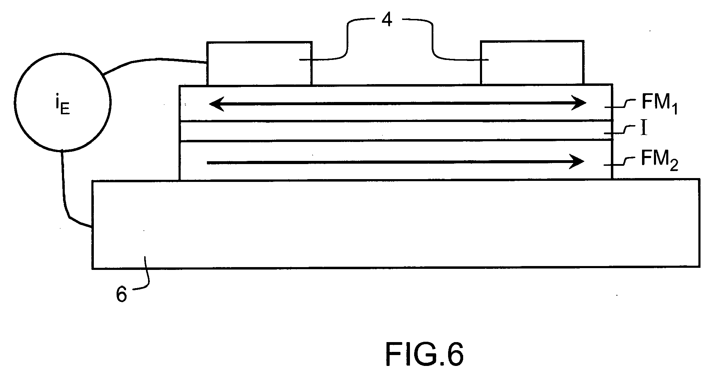

La figure 6 illustre par une vue latérale le même exemple de memristor magnéto-résistif selon l'invention en forme de barreau que celui des figures 3 et 5, lors de l'écriture de l'état initial. L'état initial est soit l'état parallèle P des aimantations pour une synapse inhibitrice, soit l'état antiparallèle AP pour une synapse excitatrice. Cet état initial peut être contrôlé par transfert de spin vertical en appliquant un courant $i_E$ entre les électrodes 4 et 6. Suivant la polarité du courant $i_E$ injecté et pour une densité du courant $i_E$ suffisamment élevée, de l'ordre de $10^7$ A.cm$^{-2}$, un couple de transfert de spin impose l'état P ou l'état AP.

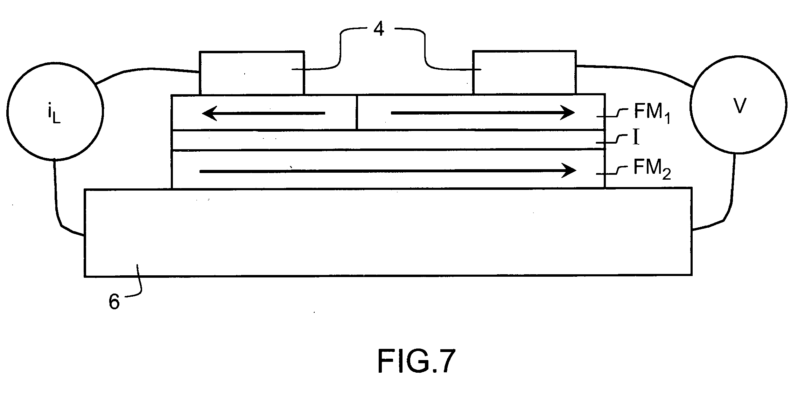

La figure 7 illustre par une vue latérale le même exemple de memristor magnéto-résistif selon l'invention en forme de barreau que celui des figures 3, 5 et 6, lors de la lecture de l'état de résistance. La lecture de l'état de résistance se fait en mesurant la tension V entre les électrodes 4 et 6. Pour ce faire, un courant $i_L$ est également injecté entre les électrodes 4 et 6, suffisamment faible pour ne pas perturber la configuration magnétique ($i_L << i_E$).

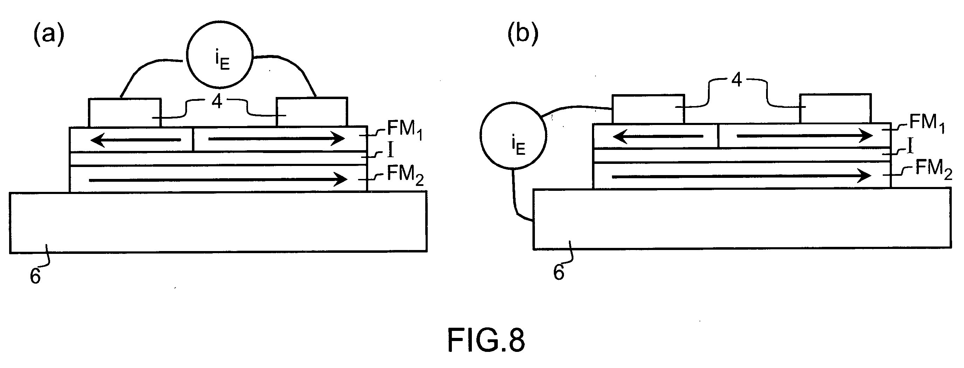

La figure 8 illustre par une vue latérale le même exemple de memristor magnéto-résistif selon l'invention en forme de barreau que celui des figures 3, 5, 6 et 7, lors de l'écriture d'un état de résistance différent de l'état initial, toujours par déplacement de la paroi par transfert de spin. Ainsi, après l'écriture de l'état initial, les écritures postérieures peuvent s'effectuer de deux manières différentes. Une première technique est d'appliquer le courant $i_E$ latéralement entre les électrodes 4, comme illustré par l'exemple (a) de la figure 8. Une deuxième technique est d'injecter le courant $i_E$ verticalement entre les électrodes 4 et 6 comme illustré par l'exemple (b) de la figure 8.

Un memristor selon l'invention décrite précédemment a encore pour principal avantage que, même mis hors tension, il conserve sa valeur de résistance telle qu'elle était au moment de la mise hors tension.

**Revendications**

1. Utilisation d'un dispositif à résistance ajustable comportant un empilement de deux couches magnétiques séparées par une couche isolante ou semi-conductrice (I), l'empilement formant un barreau (5), une première des deux couches magnétiques (FM1) comportant une paroi magnétique séparant deux zones ayant des directions d'aimantation homogènes sensiblement parallèles à l'axe longitudinal du barreau (5) mais de sens opposés, la paroi magnétique étant sensiblement perpendiculaire à l'axe longitudinal du barreau (5), la deuxième des deux couches magnétiques (FM2) ayant une direction d'aimantation homogène sensiblement parallèle à l'axe longitudinal du barreau (5), le dispositif étant utilisé pour ajuster continûment une résistance sur une plage continue de valeurs s'étendant continûment entre une résistance minimale dans laquelle les directions d'aimantation dans la première et la deuxième couches sont parallèles et une résistance maximale dans laquelle les directions d'aimantation dans la première et la deuxième couches sont orientées dans des directions opposées, par application d'un courant électrique polarisé en spin à travers la paroi magnétique permettant de la déplacer, ledit dispositif conservant sa valeur de résistance lorsqu'on le met hors tension.

2. Utilisation selon la revendication 1, dans laquelle les moyens pour déplacer la paroi magnétique le long du barreau incluent au moins deux électrodes (4, 6) disposées sur la première couche magnétique (FM$_1$) et/ou sur la deuxième couche magnétique (FM$_2$), lesdites électrodes permettant d'appliquer au barreau (5) le courant électrique polarisé en spin ($i_E$).

3. Utilisation selon la revendication 2, dans laquelle la paroi magnétique ne se déplace le long du barreau (5) que lorsque le courant polarisé en spin ($i_E$) appliqué entre les électrodes (4, 6) a une densité de courant supérieure à un seuil donné.

4. Utilisation selon la revendication 3, dans laquelle, au-dessus du seuil de densité de courant donné, l'amplitude (x) de déplacement de la paroi magnétique le long du barreau (5) varie linéairement avec la durée d'application (t) entre les électrodes (4, 6) du courant polarisé en spin ($i_E$).

5. Utilisation selon la revendication 4, dans laquelle le signe du courant polarisé en spin ($i_E$) appliqué entre les électrodes (4, 6) détermine le sens de déplacement de la paroi magnétique le long du barreau (5).

6. Utilisation selon la revendication 1, dans laquelle le dispositif comporte un réservoir de nucléation à une extrémité du barreau (5), de manière à faciliter la création de la paroi magnétique.

7. Utilisation selon la revendication 1, dans laquelle la paroi magnétique dans la première couche magnétique (FM$_1$) est située à une extrémité du barreau (5), la première couche (FM$_1$) ayant une seule direc-

tion d'aimantation homogène sensiblement parallèle à l'axe longitudinal du barreau (5), de telle sorte que la résistance du dispositif est égale à l'une des bornes de la plage continue de valeurs.

8. Utilisation selon la revendication 7, dans laquelle le dispositif est utilisé comme synapse excitatrice entre deux neurones dans un réseau de neurones, le courant polarisé en spin ($i_E$) appliqué au barreau (5) permettant de diminuer la valeur de la résistance à partir de la borne maximale de la plage continue de valeurs.

9. Utilisation selon la revendication 7, dans laquelle le dispositif est utilisé comme synapse inhibitrice entre deux neurones dans un réseau de neurones, le courant polarisé en spin ($i_E$) appliqué au barreau (5) permettant d'augmenter la valeur de la résistance à partir de la borne minimale de la plage continue de valeurs.

10. Utilisation selon l'une quelconque des revendication 8 ou 9, dans laquelle le dispositif comporte des pièges artificiels pour la paroi, de manière à reproduire des fonctions synaptiques.

11. Utilisation selon la revendication 1, dans laquelle la première couche magnétique ($FM_1$) est une couche ferromagnétique.

12. Utilisation selon la revendication 2, dans laquelle la couche ferromagnétique contient un matériau magnétique à anisotropie planaire, pouvant être un alliage NiFe ou un alliage CoFeB.

13. Utilisation selon la revendication 12, dans laquelle la couche ferromagnétique contient un matériau magnétique à anisotropie perpendiculaire, pouvant être un alliage CoPt, ou un alliage FePt, ou un alliage FePd, ou un empilement Co/Ni, ou un empilement $Co/Al_2O_3$.

14. Utilisation selon la revendication 1, dans laquelle la deuxième couche magnétique ($FM_2$) est une couche ferromagnétique, pouvant contenir du cobalt, ou un alliage NiFe, ou un alliage CoPt, ou un alliage FePt, ou un alliage FePd, ou un empilement Co/Ni ou un empilement $Co/Al_2O_3$.

15. Utilisation selon la revendication 1, dans laquelle la deuxième couche magnétique ($FM_2$) est une couche ferromagnétique contenant un antiferromagnétique synthétique du type CoFeB/Ru/CoFeB.

**Patentansprüche**

1. Verwendung einer justierbaren Widerstandsvorrichtung, die einen Stapel von zwei magnetischen Schichten umfasst, die durch eine Isolierschicht oder eine Halbleiterschicht (I) getrennt sind, wobei der Stapel einen Stab (5) bildet, wobei eine erste der zwei magnetischen Schichten (FM1) eine magnetische Wand umfasst, die zwei homogene Magnetisierungsrichtungen im Wesentlichen parallel zur Längsachse des Stabs (5), aber in entgegengesetzten Richtungen umfasst, wobei die magnetische Wand im Wesentlichen lotrecht zur Längsachse des Stabs (5) ist, wobei die zweite der magnetischen Schichten (FM2) eine homogene Magnetisierungsrichtung im Wesentlichen parallel zur Längsachse des Stabs (5) hat, wobei die Vorrichtung zum kontinuierlichen Justieren eines Widerstands in einem kontinuierlichen Wertebereich benutzt wird, der kontinuierlich zwischen einem minimalen Widerstand, in dem die Magnetisierungsrichtungen in der ersten und der zweiten Schicht parallel sind, und einem maximalen Widerstand verläuft, in dem die Magnetisierungsrichtungen in der ersten und der zweiten Schicht in entgegengesetzten Richtungen orientiert sind, durch Applizieren eines spinpolarisierten elektrischen Stroms durch die magnetische Wand, damit diese bewegt werden kann, wobei die Vorrichtung ihren Widerstandswert beibehält, wenn sie außer Spannung gesetzt wird.

2. Verwendung nach Anspruch 1, wobei die Mittel zum Bewegen der magnetischen Wand entlang dem Stab wenigstens zwei Elektroden (4, 6) beinhalten, die auf der ersten magnetischen Schicht ($FM_1$) und/oder auf der zweiten magnetischen Schicht ($FM_2$) angeordnet sind, wobei die Elektroden das Applizieren des spinpolarisierten ($i_E$) elektrischen Stroms auf den Stab (5) zulassen.

3. Verwendung nach Anspruch 2, wobei die magnetische Wand sich nur dann entlang des Stabs (5) bewegt, wenn der zwischen den Elektroden (4, 6) applizierte spinpolarisierte ($i_E$) elektrische Strom eine Stromdichte hat, die höher ist als ein gegebener Schwellenwert.

4. Verwendung nach Anspruch 3, wobei oberhalb des Dichteschwellenwertes des gegebenen Stroms die Bewegungsamplitude (x) der magnetischen Wand entlang des Stabs (5) linear mit der Applikationsdauer (t) des spinpolarisierten ($i_E$) Stroms zwischen den Elektroden (4, 6) variiert.

5. Verwendung nach Anspruch 4, wobei das Vorzeichen des zwischen den Elektroden (4, 6) applizierten spinpolarisierten ($i_E$) Stroms die Bewegungsrichtung der magnetischen Wand entlang des Stabs (5) bestimmt.

6. Verwendung nach Anspruch 1, wobei die Vorrichtung ein Nukleationsresemoir an einem Ende des Stabs (5) umfasst, so dass die Erzeugung der magnetischen Wand erleichtert wird.

7. Verwendung nach Anspruch 1, bei der sich die magnetische Wand in der ersten magnetischen Schicht ($FM_1$) an einem Ende des Stabs (5) befindet, wobei die erste Schicht ($FM_1$) eine einzige homogene Magnetisierungsrichtung im Wesentlichen parallel zur Längsachse des Stabs (5) hat, so dass der Widerstand der Vorrichtung gleich dem an einem der Pole des kontinuierlichen Wertebereichs ist.

8. Verwendung nach Anspruch 7, bei der die Vorrichtung als Anregungssynapse zwischen zwei Neuronen in einem neuronalen Netzwerk benutzt wird, wobei es der auf den Stab (5) applizierte spinpolarisierte ($i_E$) Strom zulässt, den Wert des Widerstands auf der Basis des maximalen Pols des kontinuierlichen Wertebereichs zu senken.

9. Verwendung nach Anspruch 7, bei der die Vorrichtung als Sperrsynapse zwischen zwei Neuronen in einem neuronalen Netzwerk benutzt wird, wobei der auf den Stab (5) applizierte spinpolarisierte ($i_E$) Strom es zulässt, den Wert des Widerstands auf der Basis des minimalen Pols des kontinuierlichen Wertebereichs zu erhöhen.

10. Verwendung nach einem der Ansprüche 8 oder 9, wobei die Vorrichtung künstliche Fallen für die Wand umfasst, um synaptische Funktionen zu reproduzieren.

11. Verwendung nach Anspruch 1, wobei die erste magnetische Schicht ($FM_1$) eine ferromagnetische Schicht ist.

12. Verwendung nach Anspruch 2, wobei die ferromagnetische Schicht ein magnetisches Material mit planarer Anisotropie enthält, das eine NiFe- oder eine CoFeB-Legierung sein kann.

13. Verwendung nach Anspruch 12, wobei die ferromagnetische Schicht ein magnetisches Material mit lotrechter Anisotropie enthält, das eine CoPt-Legierung oder eine FePt-Legierung oder eine FePd-Legierung oder ein Co/Ni-Stapel oder ein $Co/Al_2O_3$-Stapel sein kann.

14. Verwendung nach Anspruch 1, wobei die zweite magnetische Schicht ($FM_2$) eine ferromagnetische Schicht ist, die Kobalt oder eine NiFe-Legierung oder eine CoPt-Legierung oder eine FePt-Legierung oder eine FePd-Legierung oder ein Co/Ni-Stapel oder ein $Co/Al_2O_3$-Stapel sein kann.

15. Verwendung nach Anspruch 1, bei der die zweite

magnetische Schicht ($FM_2$) eine ferromagnetische Schicht ist, die ein synthetisches Antiferromagnetikum des Typs CoFeB/Ru/CoFeB enthält.

## Claims

1. Use of a device having an adjustable resistor comprising a stack of two magnetic layers which are separated by an insulating or semi-conductive layer (I), the stack forming a bar (5), a first of the two magnetic layers (FM1) comprising a magnetic wall which separates two zones having homogeneous magnetisation directions which are substantially parallel with the longitudinal axis of the bar (5) but have opposing directions, the magnetic wall being substantially perpendicular to the longitudinal axis of the bar (5), the second of the two magnetic layers (FM2) having a homogeneous magnetisation direction which is substantially parallel with the longitudinal axis of the bar (5), the device being used to continuously adjust a resistance over a continuous range of values which extends continuously between a minimal resistance in which the magnetisation directions in the first and the second layers are parallel and a maximum resistance in which the magnetisation directions in the first and second layers are oriented in opposite directions, by applying an electric current which is spin polarised through the magnetic wall which enables it to be moved, the device retaining its resistance value when it is switched off.

2. Use according to claim 1, wherein the means for moving the magnetic wall along the bar include at least two electrodes (4, 6) which are arranged on the first magnetic layer ($FM_1$) and/or on the second magnetic layer ($FM_2$), the electrodes enabling the spinpolarised electric current ($i_E$) to be applied to the bar (5).

3. Use according to claim 2, wherein the magnetic wall moves along the bar (5) only when the spin-polarised current ($i_E$) which is applied between the electrodes (4, 6) has a current density which is greater than a specific threshold.

4. Use according to claim 3, wherein, above the specific current density threshold, the displacement amplitude (x) of the magnetic wall along the bar (5) varies in a linear manner with the application duration (t) of the spin polarised current ($i_E$) between the electrodes (4, 6).

5. Use according to claim 4, wherein the sign of the spin polarised current ($i_E$) applied between the electrodes (4, 6) determines the displacement direction of the magnetic wall along the bar (5).

6. Use according to claim 1, wherein the device comprises a nucleation tank at one end of the bar (5), in order to facilitate the production of the magnetic wall.

7. Use according to claim 1, wherein the magnetic wall in the first magnetic layer ($FM_1$) is located at one end of the bar (5), the first layer ($FM_1$) having a single homogeneous magnetisation direction which is substantially parallel with the longitudinal axis of the bar (5), so that the resistance of the device is equal to one of the limit values of the continuous range of values.

8. Use according to claim 7, wherein the device is used as an exciting synapse between two neurons in a neuron network, the spin polarised current ($i_E$) applied to the bar (5) enabling the resistance value to be reduced from the maximum limit value of the continuous range of values.

9. Use according to claim 7, wherein the device is used as an inhibitory synapse between two neurons in a neuron network, the spin polarised current ($i_E$) applied to the bar (5) enabling the resistance value to be increased from the minimum limit value of the continuous range of values.

10. Use according to any of claims 8 or 9, wherein the device comprises artificial traps for the wall, in order to reproduce synaptic functions.

11. Use according to claim 1, wherein the first magnetic layer ($FM_1$) is a ferromagnetic layer.

12. Use according to claim 2, wherein the ferromagnetic layer contains a magnetic material with planar anisotropy, which may be an NiFe alloy or a CoFeB alloy.

13. Use according to claim 12, wherein the ferromagnetic layer contains a magnetic material with perpendicular anisotropy, which may be a CoPt alloy, or an FePt alloy, or an FePd alloy, or a Co/Ni stack or a $Co/Al_2O_3$ stack.

14. Use according to claim 1, wherein the second magnetic layer ($FM_2$) is a ferromagnetic layer which may contain cobalt, or an NiFe alloy, or a CoPt alloy or an FePt alloy, or an FePd alloy, or a Co/Ni stack or a $Co/Al_2O_3$ stack.

15. Use according to claim 1, wherein the second magnetic layer ($FM_2$) is a ferromagnetic layer which contains a synthetic antiferromagnetic substance of the type CoFeB/Ru/CoFeB.

FIG.1

EP 2 425 434 B1

état initial AP

synapse excitatrice

état initial P

synapse inhibitrice

FIG.2

EP 2 425 434 B1

FIG.3

EP 2 425 434 B1

(a)

(b)

(c)

FIG.4

FIG.5

EP 2 425 434 B1

FIG.6

FIG.7

(a)

$i_E$

4

FM$_1$

I

FM$_2$

6

(b)

4

$i_E$

FM$_1$

I

FM$_2$

6

FIG.8

EP 2 425 434 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2006064022 A1

**Littérature non-brevet citée dans la description**

- **D. B. STRUKOV et al.** *Nature,* 2008, vol. 453, 80
- **J.J. YANG et al.** *Nature Nano,* 2008, vol. 3, 429
- **J. GROLLIER et al.** *Appl. Phys. Lett.,* 2003, vol. 83, 509
- **X. WANG et al.** *IEEE Electron Device Letters,* 2009, vol. 30, 741